Europäisches Patentamt

European Patent Office

Office européen des brevets

(19)

(11) Numéro de publication: **0 145 543**
**B1**

(12) **FASCICULE DE BREVET EUROPEEN**

(45) Date de publication du fascicule du brevet: **11.05.88**

(51) Int. Cl.⁴: **H 04 N 3/15,** H 04 N 5/32

(21) Numéro de dépôt: **84402228.5**

(22) Date de dépôt: **06.11.84**

(54) **Barrette multi-linéaire à transfert de charge.**

(30) Priorité: **10.11.83 FR 8317915**

(43) Date de publication de la demande:
**19.06.85 Bulletin 85/25**

(45) Mention de la délivrance du brevet:
**11.05.88 Bulletin 88/19**

(84) Etats contractants désignés:
**DE FR GB NL**

(56) Documents cités:
**EP-A-0 064 890**
**US-A-4 054 797**

**PATENTS ABSTRACTS OF JAPAN, vol. 5, no.
167(E-79)839r, 24 octobre 1981, page 78E79**

**NUCLEAR INSTRUMENTS & METHODS IN
PHYSICS RESEARCH, vol. 201, no. 1, octobre
1982, pages 53-64, North-Holland Publishing
Company, Amsterdam, NL; N.M. ALLINSON:
"Solid-state imaging arrays for X-ray detection"**

(73) Titulaire: **THOMSON-CSF
173, Boulevard Haussmann
F-75379 Paris Cédex 08 (FR)**

(72) Inventeur: **Berger, Jean-Luc
THOMSON-CSF SCPI 173, bld Haussmann
F-75379 Paris Cedex 08 (FR)**
Inventeur: **Descure, Pierre
THOMSON-CSF SCPI 173, bld Haussmann
F-75379 Paris Cedex 08 (FR)**

(74) Mandataire: **Mayeux, Michèle
THOMSON-CSF SCPI 19, avenue de Messine
F-75008 Paris (FR)**

(56) References cited:

**PATENTS ABSTRACTS OF JAPAN, vol. 6, no.
230(E-142)1108r, 16 novembre 1982, page
44E142**

**PATENTS ABSTRACTS OF JAPAN, vol. 6, no.
160(E-126)1038r, 21 aou7t 1982, page 63E126**

EP 0 145 543 B1

## Description

La présente invention concerne une barrette multi-linéaire à transfert de charge.

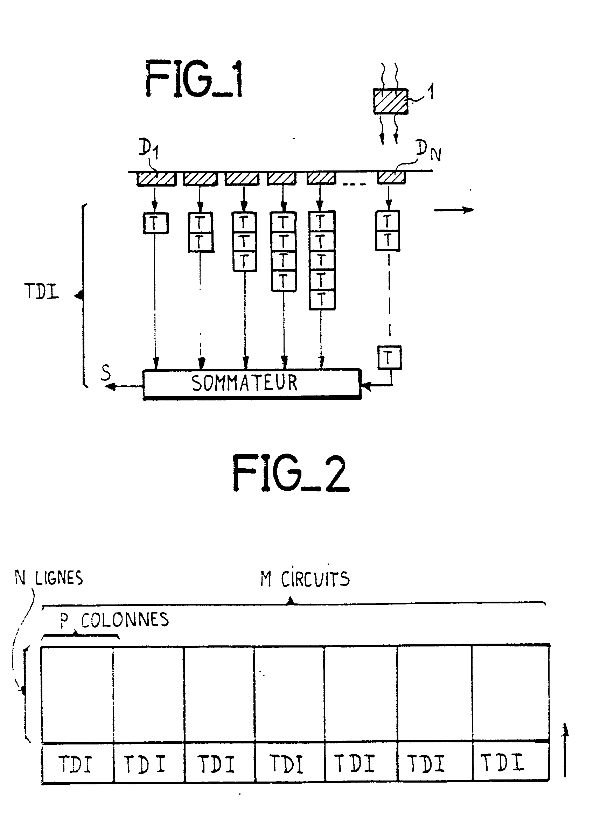

Selon l'art antérieur, on connait de telles barrettes qui vont être décrites en se référant aux figures 1 et 2. Dans ces barrettes, on utilise N éléments photosensibles alignés, appelés $D_1$, $D_2$, ..., $D_N$ sur la figure 1. Ces N éléments photosensibles reçoivent successivement le rayonnement à détecter.

Sur la figure 1, on a indiqué par une flèche allant de gauche à droite le sens de défilement de la barrette devant l'objet ou le corps 1 qui émet le rayonnement à détecter. Le temps d'intégration est ainsi multiplié par un facteur N à condition de sommer en synchronisme avec le défilement les informations recueillies sur les différents détecteurs. Pour sommer en phase les informations collectées il faut leur apporter des retards de valeurs T, 2T, 3T, ..., NT, où T est le temps de passage de l'objet ou du corps qui émet le rayonnement devant chaque détecteur, c'est aussi le temps d'intégration de chaque détecteur. On a représenté schématiquement sur la figure 1 qu'un retard T est apporté à l'information issue du détecteur $D_1$ avant d'être envoyée sur un sommateur, un retard 2T est apporté à l'information issue du détecteur $D_2$, ..., et ainsi de suite.

Le dispositif représenté sur la figure 1—hormis les détecteurs $D_1$ à $D_N$—est connu dans la littérature anglo-saxonne sous le nom de "Time Delay Intégration" ou TDI et c'est par ces initiales que nous le désignerons par la suite.

Il est connu de réaliser un TDI par un registre à décalages à transfert de charge à entrées parallèles et sortie série. Dans l'exemple de la figure 1, l'information issue du détecteur $D_N$ est envoyée sur le premier étage du registre, puis se trouve transférée dans le deuxième étage où elle est sommée avec l'information issue du détecteur $D_{n-1}$, ..., et ainsi de suite.

Par le brevet américain US—A—4.054.797, on connaît un TDI, pour le rayonnement infra-rouge, muni de registres à décalages à transfert de charge à entrées, en parallèle, latérales et à sortie série et dont les étages ont une capacité croissante selon le sens de transfert des charges.

Dans ce brevet, il est expliqué à la colonne 4, lignes 6 à 12, qu'on entre les informations sur les TDI en tensions, c'est-a-dire que les charges stockées dans les détecteurs sont lues en tensions et ce sont des tensions qui commandent l'injection des charges dans les TDI.

Pour réaliser une barrette multi-linéaire à transfert de charge de très grandes dimensions, de 30 cm de long par exemple, et qui soit utilisable pour capter des images radiologiques on utilise un grand nombre de dispositifs tel que celui représenté sur la figure 1. On juxtapose sur un support M circuits comportant chacun N lignes et P colonnes de détecteurs, avec les N détecteurs d'une même colonne reliés à un TDI comme sur la figure 1.

On obtient ainsi par exemple, une barrette de 50 cm de long, constituée de M=50 barrettes élementaires comportant chacune P=40 colonnes de détecteurs, et d'1 cm de large, avec N, le nombre de lignes, étal à 20.

La présente invention concerne une barrette multi-linéaire à transfert de charge utilisée pour capter des images radiologiques et dans laquelle on a résolu divers problèmes liés à l'utilisation de rayons X.

Ces problèmes sont dus notamment:

aux détecteurs, qui ne doivent pas présenter de dérives de leurs caractéristiques lorsqu'ils reçoivent des rayons X;

à la polarisation des détecteurs qu'il n'est pas possible de réaliser sur la zone photosensible soumise au rayonnement;

à la capacité importante des détecteurs et des connexions qui relient les détecteurs à la partie traitement de l'information placée à l'abri du rayonnement.

La présente invention concerne une barrette multi-linéaire à transfert de charge comportant plusieurs lignes de détecteurs photosensibles, chaque ligne recevant successivement le rayonnement à détecter et comportant des reigstres à décalages à transfert de charge qui assurent la sommation en phase des informations collectées sur les détecteurs occupant une même position sur les diverses lignes, caractérisée:

par le fait que cette barrette est adaptée pour capter des images radiologiques, les détecteurs photosensibles étant des photodiodes devant lesquelles est placé un scintillateur et un écran étant disposé pour protéger du rayonnement à détecter toute la barrette excepté les photodiodes, et leurs connexions;

par la présence d'un dispositif d'injection en charges de l'information entre chaque connexion reliée à un détecteur et une entrée d'un registre à décalages à transfert de charge, ce dispositif comportant notamment une diode d'injection des charges reliée à l'une des connexions et une grille écran portée à un potentiel constant qui assure la polarisation du détecteur.

Les barrettes multi-linéaire à transfert de charge utilisées pour capter des images radiologiques sont particulièrement intéresantes car elles permettent de diminuer la dose de rayons X utilisée, pour un même temps d'exposition. En effet, une barrette avec N éléments photosensibles alignés permet de multiplier par N le temps d'intégration et les bruits de lecture s'ajoutant de façon quadratique, on obtient un gain sur le rapport signal sur bruit égal à N. Cette augmentation du rapport signal sur bruit permet de diminuer la dose de rayons X utilisée, pour un même temps d'exposition.

Pour l'utilisation en radiologie, on choisit comme détecteurs des photodiodes qui ne présentent pas de dérives de leurs caractéristiques lorsqu'elles reçoivent des rayons X, ce qui n'est pas le cas par exemple d'autres détecteurs comme les photo-MOS. En effet, on place un scintillateur devant la zone photosensible, avec entre le scintillateur et la zone photosensible une couche isolante. Ce scintillateur transforme les rayons X en lumière visible mais cela n'empêche pas que la zone photosensible soit traversée par un flux de rayons X.

Selon l'invention, on utilise des dispositifs d'injection en charges ou DIC qui injectent sous forme de charges dans les TDI les informations collectées sur les détecteurs, sans conversion préalable en tensions.

Ces DIC permettent de réaliser une adaptation d'impédance entre d'une part la capacité importante de chaque photo-diode et de la connexion qui la relie à la partie traitement de l'information de la barrette placée à l'abri du rayonnement et donc éloignée des photodiodes, et d'autre part, la faible capacité d'un étage de registre à décalages à transfert de charge. On réalise ainsi une injection précise et efficace.

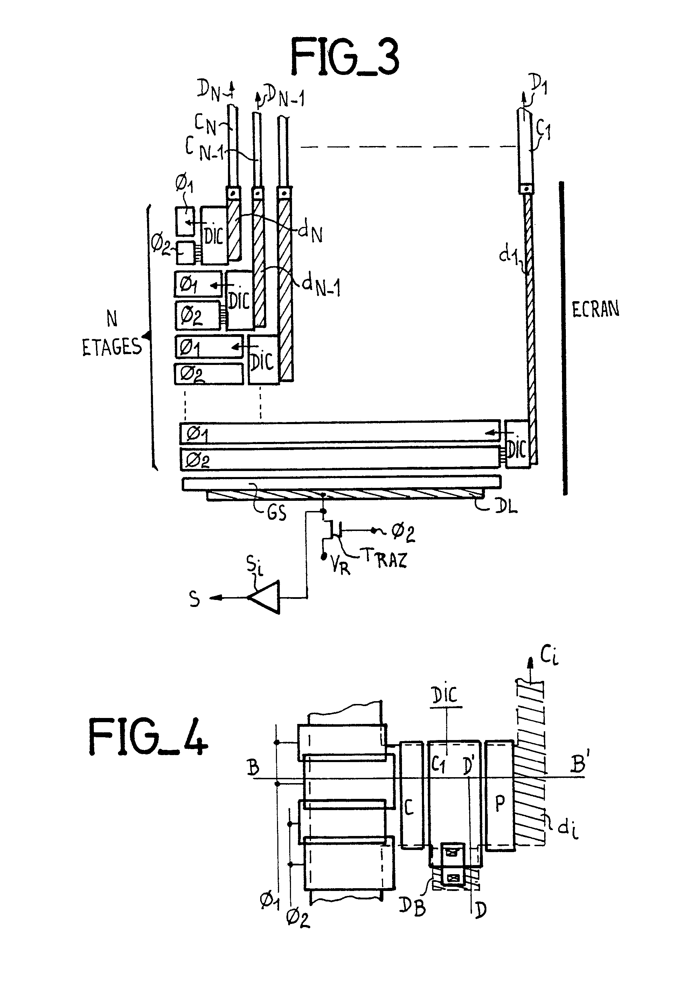

Lorsqu'on entre les informations sur les TDI en tensions, on ne dispose, dans le cas des applications en radiologie où les capacités des détecteurs et de leurs connexions sont importantes, que de faibles tensions pour commander l'injection, ce qui est un inconvénient. Il est alors possible comme dans le brevent américain US—A—4.054.797, figure 3, d'amplifier la tension qui commande l'injection mais cette solution présente l'inconvénient d'augmenter l'encombrement de la barrette.

Selon l'invention, on utilise un DIC qui comporte notamment une diode d'injection des charges reliée à l'une des connexions et une grille-écran portée à un potentiel constant qui assure la polarisation d'un détecteur. Ainsi, la polarisation des photodiodes est assurée par les DIC qui sont placés à l'abri du rayonnement.

L'injection est encore améliorée par divers perfectionnements tels que l'utilisation de deux charges d'entraînement. Dans un mode de réalisation préféré, on utilise un drain d'évacuation des charges en excès placé au niveau des DIC. Les diodes utilisées ont une forte capacité et s'il y a suréclairement ce sont d'abord les registres à décalages à transfert de charge qui sont saturés. L'utilisation de drains d'évacuation au niveau des DIC permet de protéger les registres sans augmentation sensible du l'encombrement.

D'autres objets, caractéristiques et résultats de l'invention ressortiront de la description suivante, donnée à titre d'exemple non limitatif et illustrée par les figures annexées qui représentent:

les figures 1 et 2, des schémas de l'art antérieur, montrant les connexions entre un TDI et des détecteurs $D_1$ à $D_N$, et montrant la structure générale d'une barrette multi-linéaire à transfert de charge;

la figure 3, le schéma d'un mode de réalisation selon l'invention d'un TDI;

la figure 4, un schéma montrant de façon plus détaillée que la figure 3 la structure d'un mode de réalisation préféré d'un dispositif d'injection en charges;

les figures 5a, b, et 6a, b, des vues en coupe effectuées sur le schéma de la figure 4 et des diagrammes expliquant le fonctionnement;

la figure 7, le schéma d'un mode de réalisation d'une barrette élémentaire;

la figure 8, une vue en coupe de la figure 7.

Sur les différentes figures, les mêmes repères désignent les mêmes éléments, mais, pour des raisons de clarté, les cotes et proportions de divers éléments ne sont pas respectées.

Sur la figure 3 est représenté le schéma d'un mode de réalisation d'un TDI. Des connexions parallèles, verticales sur la figure, $C_1$ à $C_N$, sont reliées à des détecteurs $D_1$ à $D_N$. On rappelle qu'une barrette multi-linéaire à transfert de charge comporte plusieurs lignes d'éléments photosensibles. Chaque ligne reçoit successivement le rayonnement à détecter. Chaque TDI est relié à N détecteurs qui occupent une même position, c'est-à-dire une même colonne, sur les diverses lignes.

Chaque connexion est reliée par l'intermédiaire d'un dispositif d'injection en charges ou DIC à l'entrée d'un étage d'un registre à décalages à transfert de charge de N étages. Ce registre a des entrées, en parallèle, et latérales, et une sortie série.

Dans le mode de réalisation de la figure 3, on a utilisé un registre à décalages à transfert de charge dont chaque étage est constitué par un couple d'électrodes relié à un signal de commande $\phi_1$ et par un couple d'électrodes relié à un signal de commande $\phi_2$. Dans chaque couple, l'une des électrodes est une électrode de stockage et l'autre une électrode de transfert. La dissymétrie dans les potentiels de surface nécessaire pour rendre unilatéral le transfert est réalisée par exemple par une surépaisseur d'oxyde ou par une implantation d'impuretés de même type que le substrat.

De même, on peut utiliser un registre présentant un nombre quelconque de phases de commande. Sur la figure 3, l'injection des charges se fait sur la phase $\phi_1$.

Dans le mode de réalisation de la figure 3, les DIC sont en contact avec l'extrémité de droite des électrodes de stockage reliées au signal d'horloge $\phi_1$. Les DIC pourraient aussi, par exemple, être en contact avec l'extrémité gauche de ces électrodes ou avec leur partie supérieure.

Le sens de transfert des charges dans le registre est vertical, de bas en haut, et parallèle aux connexions. Les étages de ce registre ont une capacité croissante selon le sens du transfert. L'augmentation de capacité se fait de préférence par augmentation de la surface des électrodes. On peut doubler la capacité du registre d'un étage au suivant.

Par la connexion $C_N$ on transfère dans le registre les charges provenant du détecteur $D_N$. Ces charges sont transférées dans le registre à décalage à partir du DIC relié à la connexion $C_N$. Il y a transfert de ces charges vers l'étage suivant, puis il se produit le transfert dans cet étage du registre par la connexion $C_{N-1}$ des charges provenant du détecteur $D_{N-1}$, . . . Et ainsi de suite, . . ., le registre affecte de retards décroissants de valeurs NT, $(N-1)$. T, . . . les charges provenant des détecteurs $D_N$ à $D_1$ et ce registre réalise aussi la sommation des charges.

La disposition adoptée sur la figure 3 est particulièrement-avantageuse du point de vue de la compacité de la barrette.

Le dernier étage du registre comporte un dispositif pour lire les charges.

Ce dispositif peut être par exemple constitué par une grille de sortie $G_S$, suivie par une diode de lecture $D_L$ à laquelle sont reliés un étage suiveur $S_i$ qui fournit le signal de sortie S et par un transistor de remise à zéro $T_{RAZ}$ dont la grille est commandée par le signal $\phi_2$ et qui reçoit une tension continue $V_R$.

Pour l'utilisation en radiologie, on place un écran opaque au rayonnement X au niveau du TDI comme cela est représenté sur la figure 3.

Sur les figures 4, 5 et 6, on a représenté un mode de réalisation préféré des DIC de la figure 3.

Sur la figure 4 qui est une vue de dessus, on constate que chaque DIC comporte:

une diode d'injection des charges $d_i$ reliée à une connexion $C_i$;

une grille-écran P portée à un potentiel constant;

une grille de stockage $C_1$;

une grille d'injection C qui contrôle le passage des charges vers l'entrée d'un étage d'un registre à décalages à transfert de charge;

une diode $D_B$ d'évacuation des charges reliée latéralement à la grille de stockage $C_1$.

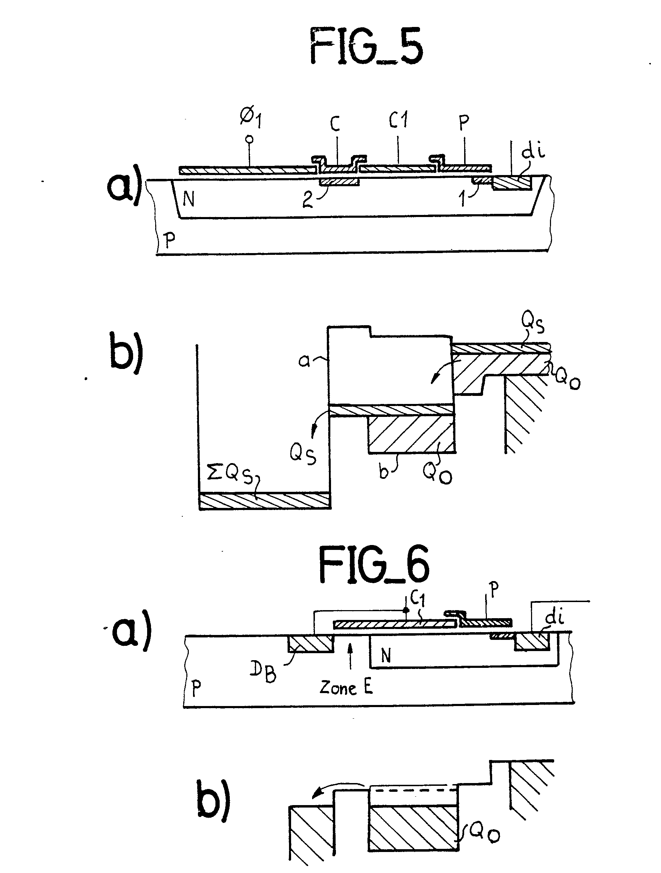

La figure 5a est une vue en coupe dans la direction BB' du dispositif de la figure 4.

On remarque que le DIC est réalisé sur une diffusion N/P. On pourrait aussi utiliser une diffusion P/N. Les transferts s'effectuent donc en volume ce qui diminue le bruit. De même, les registres comportent de préférence des diffusions pour que les tranferts s'effectuent en volume. Sous la grille P, il existe une compensation 1 qui élève partiellement le seuil et dont le rôle sera expliqué plus loin. De même, il existe une compensation 2 sous la grille C.

Sur la figure 5b, on a représenté les profils de potentiels à deux périodes a et b.

Pendant la période a, s'opère le transfert des charges vers l'étage du registre qui est représenté sur les figures 5a et b.

Les grilles $C_1$ et C sont au niveau bas.

Sur la diode d'injection $d_i$ et sous la grille-écran P se trouve la charge-signal $Q_S$ provenant du détecteure $D_i$.

Pendant la période b, les grilles $C_1$ et C sont portées à des niveaux hauts. Il y a tranfert vers ces grilles d'une quantité de charges égale à $Q_S+Q_0$, où $Q_0$ constitue une première charge d'entraînement destinée à améliorer le transfert des charges au niveau de la grille P. La charge d'entraînement $Q_0$ est retenue sous la grille $C_1$ alors que la charge-signal $Q_S$ est transférée dans le registre où elle s'ajoute aux charges-signal provenant d'autres détecteurs. On choisit les niveaux hauts appliqués aux grilles $C_1$ et C pour que la charge d'entraînement $Q_0$ soit retenue sous la grille $C_1$.

La grille-écran P sert essentiellement à la polarisation des détecteurs. Elle définit le potentiel de référence des détecteurs au début de leur temps d'intégration. Cela se produit à chaque lecture lorsque les charges en excès par rapport au potentiel de référence sont transférées sous la grille $C_1$. La compensation 1 à cheval sous la grille P et qui élève partiellement son seuil améliore ce découplage entre le potentiel de référence et le potentiel sous la grille $C_1$.

Comme la polarisation des détecteurs est réalisée par les TDI, on peut avoir une zone photosensible qui ne comporte aucun transistor MOS et aucun dispositif à transfert de charge.

Sous la grille C, il y a aussi une compensation 2 qui élève son seuil. Ainsi, lorsque les grilles C et $C_1$ passent au niveau bas, la charge d'entraînement $Q_0$ est restituée sous la grille P et la diode $d_i$ et non dans le registre.

Pour améliorer le transfert des charges-signal $Q_S$ au niveau de la grille C, on utilise une deuxième charge d'entraînement $Q_1$.

La charge d'entraînement $Q_1$ est de préférence tranférée dans le DIC en même temps que la charge-signal $Q_S$. Elle peut être générée par un éclairement supplémentaire des détecteurs ou, par exemple, par un registre à décalages à transfert de charge ou des transistors MOS assurant l'injection d'une quantité de charges supplémentaire au niveau des connexions $C_1, \ldots, C_N$ par exemple. La deuxième charge d'entraînement $Q_1$ est de l'ordre du $1/10^e$ ou du $1/20^e$ de la charge-signal moyenne, alors que la première charge d'entraînement $Q_0$ est de l'ordre de 3 à 5 fois la charge-signal maximum. Elle est transférée dans le registre en même temps que les charges-signal $Q_S$.

Le DIC des figures 4 et 5 constitue un mode de réalisation préféré, très perfectionné.

Le mode de réalisation de base d'un DIC comporte la diode $d_i$ la grille-écran P, la grille de stockage $C_1$ et la grille d'injection C. Dans des modes de réalisation plus perfectionnés, on ajoute les compensations 1 et 2 sous les grilles P et C, le système pour générer la deuxième charge d'entraînement... A partir du mode de réalisation des figures 4 et 5, découlent donc d'autres modes de réalisation de DIC, moins performants. De même les DIC et les registres peuvent fonctionner avec des tranferts en surface.

Dans le cas d'une utilisation en radiologie, les détecteurs présentent une forte capacité. En cas de suréclairement les registres sont saturés les premiers, ils peuvent avoir par exemple une capacité de stockage 10 fois plus faible que celle des détecteurs.

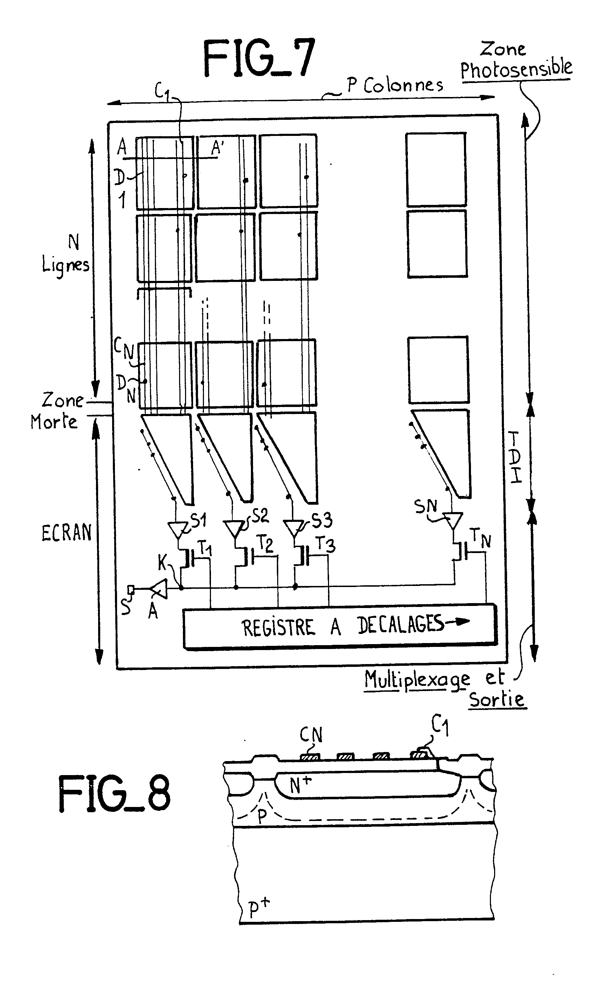

Pour des raisons d'encombrement, il n'est pas très souhaitable d'utiliser des drains d'évacuation au niveau des registres. On préfère disposer un drain d'évacuation au niveau des DIC. Dans le mode de réalisation de la figure 4, ce drain est constitué par une diode $D_B$ connectée à la grille $C_1$. La diode $D_B$ est placée latéralement par rapport à la grille $C_1$. La figure 6a est une vue en coupe selon la direction DD', D'B' indiquée sur la figure 4 et la figure 6b montre le profil de potentiel en cas de suréclairement pour le dispositif de la figure 6a. Lorsqu'il y a excès de charge sous la grille $C_1$, il y a transfert vers la diode $D_B$.

Pour obtenir un bon transfert à faible bruit, l'ensemble des grilles P, $C_1$, C ainsi que le registre à décalages à transfert de charge sont réalisés sur une diffusion, par exemple N/P sur la figure 6a, de façon à effectuer tous les transferts en volume, mais la zone diffusée N est interrompue dans la zone E—voir figure 6a—au voisinage de la diode $D_B$. Le potentiel dans cette zone est tel que le transfert s'y effectue en surface. On obtient une barrière de potentiel qui détermine la quantité maximum de charge stockable sous la grille $C_1$. Dans une variante, la zone diffusée N n'est pas interrompue dans la zone E, au voisinage de la diode $D_B$. On réalise alors sous la grille $C_1$, au voisinage de la diode $D_B$, une compensation plus forte que la compensation 2 existant sous la grille C ce qui permet d'avoir un seuil plus élevé au voisinage de la diode $D_B$ pour moduler la quantité de charge stockée sous la grille $C_1$.

On constate que sur la figure 3 les diodes d'injection des charges $D_1$ à $D_{N-1}$ débutent toutes au même niveau sur les connexions. Il serait possible de limiter la hauteur des diodes d'injection à la dimension des grilles P, $C_1$, C. . ., des DIC. L'augmentation de la surface de ces diodes permet le passage de connexions telles que celles qui amènent les signaux d'horloge $\phi_1$ et $\phi_2$ aux TDI voisins.

Sur la figure 7, on a représenté de façon détaillée l'une des barrettes élémentaires représentée sur la figure 2 et dont il faut réunir M exemplaires pour obtenir une barrette multi-linéaire à transfert de charge. L'ensemble de la barrette est de préférence réalisé sur le même substrat semi-conducteur.

Cette barrette comporte une zone photosensible constituée de N lignes et P colonnes de détecteurs.

On peut considérer que chaque colonne constitue un point de résolution. Dans le mode de réalisation de la figure 7, les détecteurs sont des photodiodes ayant une forme rectangulaire d'environ 250 microns de long et 500 microns de large. L'intervalle entre les photodiodes est d'envision 10 microns pour augmenter au maximum la sensibilité. Il y a sur chaque colonne de détecteurs, N connexions verticales $C_1$ à $C_N$ qui relient l'un des détecteurs à une entrée d'un TDI.

Ces connexions sont réalisées en matériau conducteur semi-transparent, en silicium poly-cristallin par exemple. Elle sont aussi fines que possibles pour ne pas trop diminuer la sensibilité, par exemple leur largeur est de 5 microns et elles sont séparées par un intervalle de 5 microns. Ces connexions s'étendent sur toute la largeur de la zone photosensible pour équilibrer les sensibilités de toutes les photodiodes.

Le circuit de la figure 7 comporte donc faisant suite à la zone photosensible P organes DIC et P organes TDI, c'est-à-dire un DIC et un TDI par colonne de photodiodes. Un registre à décalages adresse l'un après l'autre chacun de ces TDI.

L'adressage se fait par la grille de transistors MOS de commutation $T_1$ à $T_N$ reliés entre un point commun K et la sortie d'un étage suiveur $S_1$ à $S_N$ connecté à la sortie d'un TDI. Ces étages suiveurs délivrent une tension sur impédance moyenne. Le point K reçoit successivement les informations de chaque TDI et les délivre sur la sortie S à travers un amplificateur de sortie basse impédance A.

On peut utiliser le même registre à décalages pour adresser successivement tous les TDI d'une barrette comportant plusieurs barrettes élémentaires telle que celle de la figure 7.

On protège les DIC, les TDI et la partie multiplexage et sortie de la barrette par un écran. Une zone morte est ménagée entre la zone photosensible et les TDI pour permettre de positionner sans difficulté le bord de l'écran. Un avantage du dispositif selon l'invention est que la polarisation des détecteurs est réalisée par les DIC qui sont protégés du rayonnement.

On réalise de préférence la zone photosensible sur un substrat épitaxié, une zone P sur un substrat $P^+$ par exemple, comme on peut le voir sur la figure 8 qui est une vue en coupe d'un détecteur selon la direction AA' indiquée sur la figure 7. L'épaisseur utile de la couche épitaxiée est faible, de 15 microns environ par exemple. Les rayons X n'ont que peu de chance d'être absorbés dans cette zone ce qui générerait un afflux de charges parasites.

**Revendications**

1. Barrette multi-linéaire à transfert de charge, comportant plusieurs lignes de détecteurs photosensibles, chaque ligne recevant successivement le rayonnement à détecter et comportant des registres à décalages à transfert de charge qui assurent la sommation en phase des informations collectées sur les détecteurs ($D_1$, . . ., $D_N$) occupant une même position sur les diverse lignes, caractérisée:

par le fait que cette barrette est adaptée pour capter des images radiologiques, les détecteurs photosensibles ($D_1$, . . ., $D_N$) étant des photodiodes devant lesquelles est placé un scintillateur, et un écran étant disposé pour protéger du rayonnement à détecter toute la barrette excepté les photodiodes, et leurs connexions ($C_1$, . . ., $C_N$);

par la présence d'un dispositif d'injection en charges (DIC) de l'information entre chaque connexion ($C_1$, . . ., $C_N$) reliée à un détecteur ($D_1$, . . ., $D_N$) et une entrée d'un registre à décalages à transfert de charge, ce dispositif comportant notamment une diode d'injection ($d_i$) des charges reliée à l'une des connexions ($C_1$, . . ., $C_N$) et une grille écran (P) portée à un potentiel constant qui assure la polarisation du détecteur.

2. Barrette selon la revendication 1, caractérisée en ce que chaque dispositif d'injection en charges (DIC) comporte à la suite de la grille écran (P):

une grille ($C_1$) qui permet de retenir une quantité de charges dite première charge d'entraîne-ment ($Q_o$), destinée à améliorer le transfert des charges sous la grille-écran (P), et qui est ensuite restituée vers la grille-écran (P) et la diode d'injection ($d_i$);

une grille d'injection (C) qui contrôle le passage des charges vers l'entrée d'un étage d'un registre à décalages à transfert de charge.

3. Barrette selon la revendication 2, caractérisée en ce qu'il existe sous la grille d'injection (C) une compensation (2) qui élève son seuil.

4. Barrette selon l'une des revendications 1 à 3, caractérisée en ce qu'il existe sous la grille écran (P) une compensation qui élève partiellement son seuil.

5. Barrette selon l'une des revendications 2 à 4, caractérisée en ce qu'elle comporte des moyens permettant de superposer aux charges-signal provenant de chaque détecteur une deuxième charge d'entraînement ($Q_1$) destinée à améliorer le transfert par-dessus la grille d'injection (C) et qui est transférée dans une registre avec les charges-signal ($Q_S$).

6. Barrette selon la revendication 5, caractérisé en ce que ces moyens consistent en un éclairage supplémentaire des détecteurs.

7. Barrette selon la revendication 5, caractérisée en ce que ces moyens sont constitués par des transistors MOS ou par un registre à décalages à transfert de charges assurant l'injection d'une quantité de charge supplémentaire sur chaque connexion ($C_1, \ldots, C_N$).

8. Barrette selon l'une des revendications 2 à 7, caractérisée en ce que chaque dispositif d'injection en charges (DIC) comporte un drain d'évacuation latéral constitué par une diode ($D_B$) reliée à la grille ($C_1$) qui retient la première charge d'entraînement ($Q_0$).

9. Barrette selon l'une des revendications 1 à 8, caractérisée en ce que les registres à décalages et les dispositifs d'injection des charges comportent des diffusions de façon à ce que tous les transferts s'effectuent en volume.

10. Barrette selon les revendications 8 et 9, caractérisée en ce que la diffusion est interrompue au voisinage de la diode ($D_B$) servant de drain pour que le transfert s'effectue en surface entre le dispositif d'injection des charges (DIC) et cette diode ($d_B$).

11. Barrette selon la revendication 9, caractérisée en ce qu'il existe, sous la grille ($C_1$) qui retient la première charge d'entraînement ($Q_0$) au voisinage de la diode ($D_B$) du drain, une compensation qui élève partiellement son seuil.

12. Barrette selon l'une des revendications 1 à 11, caractérisée en ce qu'elle est réalisée sur un même substrat semi-conducteur.

13. Barrette selon l'une des revendications 1 à 12, caractérisée en ce qu'elle est constituée par la juxtaposition sur un support de barrettes élémentaires comportant N lignes et P colonnes de détecteurs, des registres à décalages à transfert de charge, des dispositifs d'injection des charges (DIC) et des organes de multiplexage et sortie.

14. Barrette selon l'une des revendications 1 à 14, caractérisée en ce que les éléments photosensibles sont réalisés sur un substrat épitaxié.

15. Barrette selon l'une des revendications 1 à 14, caractérisée en ce que les connexions ($C_1, \ldots, C_N$) s'étendent sur la totalité de la zone de la barrette comportant les éléments photosensibles.

## Patentansprüche

1. Mehrzeilige Ladungstransferleiste, mit mehreren Zeilen von lichtempfindlichen Photodetektoren, wobei jede Zeile nacheinander die zu erfassende Strahlung empfängt und Ladungstransfer-Schieberegister aufweist, die die von den dieselbe Position in den verschiedenen Zeilen einnehmenden Detektoren ($D_1, \ldots, D_N$) gesammelten Informationen phasenrichtig summiert, gekennzeichnet

dadurch, daß diese Leiste zur Aufnahme von Röntgenbildern geeignet ist, wobei die lichtempfindlichen Detektoren ($D_1, \ldots, D_N$) Photodioden sind, vor denen sich ein Szintillator befindet, und wobei ein Schirm vorgesehen ist, der die ganze Leiste mit Ausnahme der Photodioden sowie die zugehörigen Verbindungen ($C_1, \ldots, C_N$) schützt;

durch das Vorhandensein einer Informations-Ladungsinjektionsvorrichtung (DIC) zwischen jeder an einen Detektor ($D_1, \ldots, D_N$) führenden Verbindung ($C_1, \ldots, C_N$) und einem Eingang eines Ladungstransfer-Schieberegisters, wobei diese Vorrichtung insbesondere eine an eine der Verbindungen ($C_1, \ldots, C_N$) angeschlossene Ladungsinjektionsdiode ($d_i$) und ein Schirmgitter (P) aufweist, das auf einem konstanten Potential liegt und die Vorspannung des Detektors bewirkt.

2. Leiste nach Anspruch 1, dadurch gekennzeichnet, daß jede Ladungsinjektionsvorrichtung (DIC) hinter dem Schirmgitter (P)

ein Gitter ($C_1$), das eine Ladungsmenge, erste Treiberladung ($Q_0$) genannt, zurückbehält, die den Ladungstransfer unter das Schirmgitter (P) verbessern soll und die dann an das Schirmgitter (P) und die Injektionsdiode ($d_i$) abgegeben wird,

und ein Injektionsgitter (C) aufweist, das den Durchlaß der Ladungen zum Eingang einer Stufe eines Ladungstransfer-Schieberegisters steuert.

3. Leiste nach Anspruch 2, dadurch gekennzeichnet, daß sich unter dem Injektionsgitter (C) eine Kompensation (2) befindet, die seine Schwelle anhebt.

4. Leiste nach einem der Ansprüche 1 bis 3, dadurch gekennzeichnet, daß sich unter dem Schirmgitter (P) eine Kompensation befindet, die seine Schwelle teilweise anhebt.

5. Leiste nach einem der Ansprüche 2 bis 4, dadurch gekennzeichnet, daß sie Mittel aufweist, mit denen es möglich wird, dem von jedem Detektor kommenden Ladungssignal eine zweite Treiberladung ($Q_1$) zu überlagern, die den Ladungstransfer über das Injektionsgitter (C) verbessern soll und die in ein Register mit den Signalladungen ($Q_S$) übertragen wird.

6. Leiste nach Anspruch 5, dadurch gekennzeichnet, daß diese Mittel aus einer zusätzlichen Beleuchtung der Detektoren bestehen.

7. Leiste nach Anspruch 5, dadurch gekennzeichnet, daß diese Mittel von MOS-Transistoren oder von einem Ladungstransfer-Schieberegister gebildet werden, wodurch die Injektion einer zusätzlichen Ladungsmenge auf jedem Verbindung $(C_1, \ldots, C_N)$ bewirkt wird.

8. Leiste nach einem der Ansprüche 2 bis 7, dadurch gekennzeichnet, daß jede Ladungsinjektionsvorrichtung (DIC) einen von einer Diode $(D_B)$ gebildeten seitlichen Ableitdrainelektrode besitzt, die an das die erste Treiberladung $(Q_0)$ zurückhaltende Gitter $(C_1)$ angeschlossen ist.

9. Leiste nach einem der Ansprüche 1 bis 8, dadurch gekennzeichnet, daß die Schieberegister und die Ladungsinjektions-Vorrichtungen Diffusionsbereiche besitzen, sodaß alle Transfers Volumentransfers sind.

10. Leiste nach den Ansprüchen 8 und 9, dadurch gekennzeichnet, daß die Diffusion in der Nähe der zur Ableitung verwendeten Diode $(D_B)$ unterbrochen wird, sodaß der Transfer zwischen der Ladungsinjektionsvorrichtung (DIC) und dieser Diode $(d_B)$ an der Oberfläche erfolgt.

11. Leiste nach Anspruch 9, dadurch gekennzeichnet, daß sich unter dem Gitter $(C_1)$, das die erste Treiberladung $(Q_0)$ in der Nähe der Ableitdiode $(D_B)$ zurückhält, eine Kompensation befindet, die seine Schwelle teilweise anhebt.

12. Leiste nach einem der Ansprüche 1 bis 11, dadurch gekennzeichnet, daß sie auf einem gemeinsamen Halbleitersubstrat ausgebildet ist.

13. Leiste nach einem der Ansprüche 1 bis 12, dadurch gekennzeichnet, daß sie aus einer Anordnung von N Zeilen und P Spalten von Detektoren, von Ladungstransfer-Schieberegistern, von Ladungsinjektionsvorrichtungen (DIC) und von Multiplexier- und Ausgangsorganen auf einem Träger besteht.

14. Leiste nach einem der Ansprüche 1 bis 14, dadurch gekennzeichnet, daß die lichtempfindlichen Elemente auf einem Epitaxial-Substrat ausgebildet sind.

15. Leiste nach einem der Ansprüche 1 bis 14, dadurch gekennzeichnet, daß die Verbindungen $(C_1, \ldots, C_N)$ sich über die ganze Zone der die lichtempfindlichen Elemente enthaltende Leiste erstrecken.

**Claims**

1. A multi-row charge transfer array comprising a plurality of rows of light sensitive detectors, each row receiving successively the radiation to be detected and comprising charge transfer shift registers in which the informations collected from the detectors $(D_1, \ldots, D_N)$ assuming identical positions in the different rows are added up in phase, characterized:
in that this array is conceived to record X-ray pictures, the light sensitive detectors $(D_1, \ldots, D_N)$ being photodiodes, a scintillator being disposed in front of these diodes and a screen being arranged so that the entire array except the photodiodes, and their connections $(C_1, \ldots, C_N)$ are protected against the radiation to be detected;
by the presence of an information charge injection device (DIC) between each connection $(C_1, \ldots, C_N)$ connected to a detector $(D_1, \ldots, D_N)$ and an input of a charge transfer shift register, this device in particular comprising a charge injection diode $(d_I)$ connected to one of the connections $(C_1, \ldots, C_N)$, and a screen grid (P) supplied with a constant potential ensuring the biasing of the detector.

2. An array according to claim 1, characterized in that each charge injection device (DIC) comprises downstream of the screen grid (P):
a grid $(C_1)$ conceived to retain a charge quantity, called first driver charge $(Q_0)$, intended to improve the transfer of charges under the screen grid (P), this charge being then passed to the screen grid (P) and the injection diode $(d_I)$,
and an injection grid (C) controlling the transfer of the charges to an input of a charge transfer shift register stage.

3. An array according to claim 2, characterized in that a compensation (2) exists under the injection grid (C) for lifting its threshold.

4. An array according to one of claims 1 to 3, characterized in that a compensation exists under the screen grid (P) for lifting partially its threshold.

5. An array according to one of claims 2 to 4, characterized in that it includes means susceptible to superimpose a second driver charge $(Q_1)$ on the signal charges coming from each detector, this driver charge being intended, to improve the charge transfer over the injection grid (C) and being transferred into the register together with the signal charges $(Q_S)$.

6. An array according to claim 5, characterized in that these means consist in an additional illumination of the detectors.

7. An array according to claim 5, characterized in that these means are constituted by MOS transistors or charge transfer shift registers, ensuring the injection of an additional charge quantity on each connection $(C_1, \ldots, C_N)$.

8. An array according to one of claims 2 to 7, characterized in that each charge injection device (DIC) comprises a lateral evacuation drain constituted by a diode $(D_B)$ connected to the grid $(C_1)$ which retains the first driver charge $(Q_0)$.

9. An array according to one of claims 1 to 8, characterized in that the shift registers and the charge injection devices comprise diffusions so that all the transfers are volume transfers.

10. An array according to claims 8 and 9, characterized in that the diffusion is interrupted close to the diode $(D_B)$, which is used as drain, causing the transfer between the charge injection device (DIC) and this diode $(d_B)$ to be a surface transfer.

11. An array according to claim 9, characterized in that under the grid $(C_1)$ retaining the first driver charge $(Q_0)$ and in the vicinity of the drain diode $(D_B)$, a compensation exists which partially lifts its threshold.

12. An array according to one of claims 1 to 11, characterized in that it is realized on a common semiconductor substrate.

13. An array according to one of claims 1 to 12, characterized in that it is constituted by the arrangement, on a substrate, of individual arrays including N rows and P columns of detectors, of charge transfer shift registers, of charge injection devices (DIC) and of multiplexing and output units.

14. An array according to one of claims 1 to 14, characterized in that the light sensitive elements are realized on an epitaxiated substrate.

15. An array according to one of claims 1 to 14, characterized in that the connections ($C_1$, ..., $C_N$) extend over the entire zone of the array comprising the light sensitive elements.

# FIG_1

$D_1$                 1

$D_N$

TDI

S

SOMMATEUR

# FIG_2

N LIGNES           M CIRCUITS

P COLONNES

| TDI | TDI | TDI | TDI | TDI | TDI | TDI |
|-----|-----|-----|-----|-----|-----|-----|

0 145 543

FIG_3

FIG_4

2

# FIG_5

a)

b)

# FIG_6

a)

b)

# FIG_7

Zone
Photosensible

$C_1$

~ P Colonnes

A          A'

D
1

N
Lignes

$C_N$

$D_N$

Zone
Morte

TDI

ECRAN

S1          S2          S3          SN

$T_1$          $T_2$          $T_3$          $T_N$

K

S          A

REGISTRE A DECALAGES →

Multiplexage et
Sortie

# FIG_8

$C_N$          $C_1$

$N^+$

P

$P^+$